# EUROPEAN PATENT APPLICATION

(11) **EP 4 632 413 A1**
(43) Date of publication of application: **15.10.2025**
(21) Application number: 23901073.9
(22) Date of filing: 05.12.2023
(51) Int. Cl.: G01R 31/40, G01R 31/56, G01R 31/12, G01R 19/00, G01R 23/165, G01R 31/392, G01R 31/3835, H02M 1/00, H02M 1/32

(54) **FAULT DETECTION DEVICE**

(30) Priority: 05.12.2022 KR 20220167969
(71) Applicant: LG INNOTEK CO. LTD, Gangseo-gu Seoul 07796 (KR)
(72) Inventor: JANG, Ju Young, Seoul 07796 (KR)
(74) Representative: Plasseraud IP
(86) International application number: PCT/KR2023/019930
(87) International publication number: WO 2024/123055

(57) **Abstract**

A fault detection device according to an embodiment of the present invention comprises: a plurality of resistors which are connected in series between both input terminals of a converter; a sensing circuit which measures a first voltage at one of nodes between the plurality of resistors; and a processor which detects a fault by using changes in the first voltage.

## Description

### TECHNICAL FIELD

The present invention relates to a fault detection device, and more particularly, to a fault detection device, which is capable of detecting contact fault, a converter, and a battery pack.

### BACKGROUND ART

As awareness of environmental protection has increased in recent years, interest in methods of generating electricity without emitting pollutants such as carbon dioxide has grown. Particularly, in the case of photovoltaic systems using solar energy, due to technological advancements, the cost of developing and installing technology is becoming cheaper, and their spread is expanding.

The photovoltaic systems are constituted by a plurality of photovoltaic cells gathered together with each other to form a plurality of photovoltaic modules. DC power generated from a plurality of photovoltaic modules may be converted into AC power through an inverter and may be used directly in homes and industrial facilities.

The case of solar power generation, a period of inactivity in power generation is inevitable when sufficient power generation is not possible due to the nighttime period, for which sunlight is not available, or weather changes. Thus, to compensate for these disadvantages, the photovoltaic systems have to be essentially provided with batteries to ensure stable supply of power.

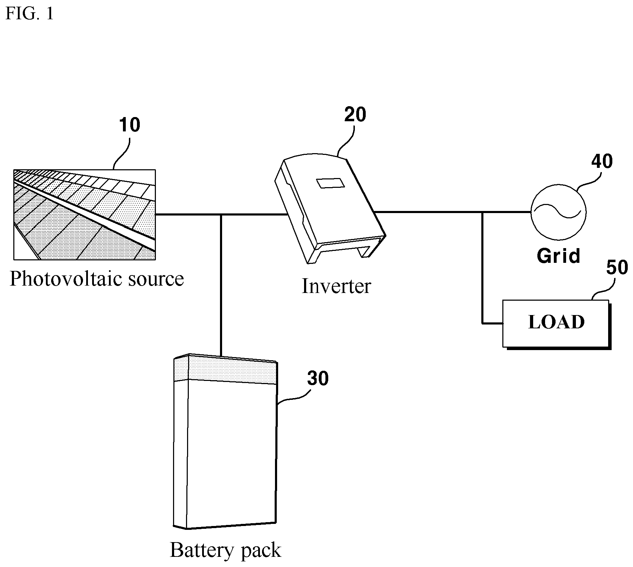

A home photovoltaic system including a battery may be configured as illustrated in FIG. 1. The inside of the battery pack may be constituted by a battery, a BMS, and a DC-DC converter. Here, when there is any problem within the battery pack to cause the battery disposed inside a battery pack and a battery pack enclosure to be in contact with each other, a problem may occur in the entire system, and thus, a technology for detecting faults is required.

### DISCLOSURE OF THE INVENTION

### TECHNICAL PROBLEM

The technical problem to be solved by the present invention is to provide a fault detection device capable of detecting a contact fault, a converter, and a battery pack.

### TECHNICAL SOLUTION

To solve the above technical problem, a fault detection device according to an embodiment of the present invention includes: a plurality of resistors connected in series between both ends of an input terminal of a converter; a sensing circuit configured to measure a first voltage at one of nodes between the plurality of resistors; and a processor configured to detect a fault by using a change in the first voltage.

In addition, the plurality of resistors may include a first resistor, a second resistor, and a third resistor, which are sequentially connected in series from a plus terminal to a minus terminal of the input terminal, wherein a node between the first resistor and the second resistor may be connected to a case of the converter, and the sensing circuit may be configured to measure the first voltage at a node between the second resistor and the third resistor.

In addition, the sensing circuit may include an inverting amplifier and a non-inverting amplifier, wherein an output of the inverting amplifier and an output of the non-inverting amplifier may be applied to the processor.

In addition, the fault detection device may further include: a first low pass filter configured to filter the output of the non-inverting amplifier; and a second low pass filter configured to filter the output of the inverting amplifier, wherein the output of the inverting amplifier and the output of the non-inverting amplifier may be applied to the processor through the first low pass filter and the second low pass filter, respectively.

In addition, the processor may be configured to detect a fault by using a difference between the output of the inverting amplifier and the output of the non-inverting amplifier.

In addition, an output terminal of the converter may be connected to a grid, and the processor may be configured to: filter the difference between the output of the inverting amplifier and the output of the non-inverting amplifier by using a band pass filter configured to filter a frequency band of the grid; and compare a magnitude level in difference between the output of the inverting amplifier and the output of the non-inverting amplifier, which are filtered, with a reference level and detect the fault.

In addition, the processor may be configured to determine that the fault occur when the magnitude level in difference between the output of the inverting amplifier and the output of the non-inverting amplifier, which are filtered, is less than the reference level for a predetermined period of time.

In addition, when detecting the fault, the processor may be configured to block connection of at least one of an input terminal or an output terminal of the converter.

In addition, the converter may include a DC-DC converter inside a battery pack, and the processor may be configured to detect a contact or ground fault of a battery of the battery pack.

In addition, the converter may include a DC-DC converter connected to a photovoltaic module, and the processor may be configured to detect a contact or ground fault of at least one terminal of both ends of an input terminal of the photovoltaic module.

To solve the above technical problem, a DC-DC converter according to an embodiment of the present invention includes: an input terminal connected to a battery or a photovoltaic panel; and a fault detection circuit configured to detect a contact or ground fault of at least one terminal of both ends of the input terminal, wherein the fault detection circuit includes one of the fault detection devices described above.

To solve the above technical problem, a battery pack according to an embodiment of the present invention includes: a battery; a DC-DC converter configured to convert a voltage of the battery; and a fault detection circuit configured to detect a contact or ground fault of the battery, wherein the fault detection circuit comprises one of the fault detection devices described above, and when the contact or ground fault of the battery is detected, the fault detection circuit is configured to block connection with the outside.

### ADVANTAGEOUS EFFECTS

According to the embodiments of the present invention, it may be possible to detect the contact (insulation breakdown) fault in battery power source of the power conversion system for the solar power and the grid-connected ESS.

### BRIEF DESCRIPTION OF THE DRAWINGS

FIG. 1 is a view for explaining a photovoltaic system to which a fault detection device is applied according to an embodiment of the present invention.
FIG. 2 is a block diagram of a fault detection device according to an embodiment of the present invention.
FIG. 3 is a block diagram of a fault detection device according to an embodiment of the present invention.
FIGS. 4 to 7 are views for explaining the fault detection device according to an embodiment of the present invention.
FIGS. 8 and 9 are views illustrating an application example to which the fault detection device is applied according to an embodiment of the present invention.
FIG. 10 is a block diagram of a DC-DC converter according to an embodiment of the present invention.
FIG. 11 is a block diagram of a battery pack according to an embodiment of the present invention.
FIG. 12 is a flowchart of a fault detection method according to an embodiment of the present invention.
FIG. 13 is a flowchart of a fault detection method according to an embodiment of the present invention.

### MODE FOR CARRYING OUT THE INVENTION

Hereinafter, preferred embodiments of the present invention will be described in detail with reference to the accompanying drawings.

However, the technical idea of the present invention is not limited to some of the embodiments described, but may be implemented in various different forms, and one or more of the components in embodiments may be selectively combined or substituted for use even within the scope of the technical idea of the present invention.

In addition, terms (including technical and scientific terms) used in the embodiments of the present invention may be interpreted as having a meaning that may be generally understood by a person of ordinary skill in the technical field to which the present invention belongs, unless explicitly and specifically defined and described, and the terms that are commonly used, such as terms defined in a dictionary, may be interpreted in consideration of the contextual meaning of the relevant technology.

In addition, the terms used in the embodiments of the present invention are for the purpose of describing the embodiments and are not intended to limit the present invention.

In this specification, the singular may also include the plural unless specifically stated otherwise in the phrase, and when it is described as "A and (or at least one) of B, C", it may include one or more of all combinations that may be combined with A, B, C.

In addition, in describing components of the embodiments of the present invention, the terms such as first, second, A, B, (A), (B), etc. may be used. These terms are only intended to distinguish one component from another and are not intended to limit the nature, order, or sequence of the component.

In addition, when a component is described as being 'connected', 'coupled', or 'linked' to another component, it may include not only cases where the component is 'connected', 'coupled', or 'linked' directly to the other component, but also cases in which the component is 'connected', 'coupled', or 'linked' by another component between the component and the other component.

In addition, when described as being formed or arranged "above (upper)" or "below (lower)" each component, "above (upper)" or "below (lower)" includes not only the case where the two components are in direct contact with each other, but also the case in which one or more other components are formed or arranged between the two components. In addition, when expressed as "above (upper)" or "below (lower)", it may include the meaning of not only the upward direction but also the downward direction based on one component.

A modified example of the present embodiment may include some configurations of some embodiment and some configurations of other embodiments. That is, the modified example may include one embodiment among various embodiments, but may omit some components and include some components of corresponding other embodiments. Alternatively, vice versa may be possible. Features, structures, and effects described in the embodiments are incorporated into at least one embodiment, but are not limited to only one embodiment. Moreover, features, structures, and effects exemplified in one embodiment can easily be combined and modified for another embodiment by those skilled in the art. Therefore, contents related to these combinations and modifications should be construed as falling within the scope of the embodiments.

FIG. 1 is a view for explaining a photovoltaic system to which a fault detection device is applied according to an embodiment of the present invention.

As illustrated in FIG. 1, a photovoltaic system may include a photovoltaic source 10, an inverter 20, a battery pack 30, and a load 50. However, it will be understood by those skilled in the art that other general components may be included in the photovoltaic system in addition to the components illustrated in FIG. 1. For example, a photovoltaic system may further include a grid 40. Alternatively, it will be understood by those skilled in the art that in other embodiments, some of the components illustrated in FIG. 1 may be omitted.

The photovoltaic source 10 may be constituted by a plurality of photovoltaic modules in which photovoltaic cells are gathered, and each of the photovoltaic cell in which a P-type semiconductor and an N-type semiconductor are bonded to each other generates electricity using light. Specifically, when light is shone on the photovoltaic cell, electrons and holes are generated therein. The generated charges move to each of the P pole and N pole, and this action generates a potential difference between the P pole and N pole, and when the load is connected to the photovoltaic cell, current flows. Here, the photovoltaic cell means the smallest unit that generates electricity, and the photovoltaic cells may be gathered together to form the battery module, and the battery modules may again form an array connected in series/parallel to form the photovoltaic source 10.

The inverter 20 may convert DC (direct current) power generated from the photovoltaic source 10 by a photoelectric effect into AC (alternating current) power to supply the power to the grid 40 or the load 50. Here, the grid 40 may mean a system (GRID) for transmitting and distributing the power generated from the photovoltaic system. An amount of power generated from the photovoltaic source 10 is continuously changed due to external factors such as time factors such as sunrise and sunset, and weather. Thus, the inverter 20 controls the voltage generated from the photovoltaic source 10 to find maximum power, thereby supplying the maximum power to the grid 40. Here, when the power for driving the inverter is lower than output power of the inverter, the inverter 20 may consume power from the grid 40 in reverse. Of course, in this case, the inverter may block the power flowing into the grid 40 to prevent the power from being reversed. Thus, various optimization control methods are applied to the photovoltaic system to enable the operation of the inverter 20 described above to be performed more efficiently, thereby extracting the maximum power from the photovoltaic source 10. Al maximum power point (MPP) method for the representative photovoltaic sources 10 include a perturbation and observation (PO) method, an incremental conductance (IC) control method, and a constant voltage (CV) control method. Here, the PO method is a method for periodically measuring the voltage and current of the photovoltaic source 10 to calculate the power and then track the MPP using the power value. The IC control method is a method for measuring the voltage and current generated from the photovoltaic source 10 to control the voltage and current so that a rate of change in power for a change in a terminal voltage operating point of the array becomes '0'. The CV control method is a method for controlling the photovoltaic source 10 to a constant reference voltage (REF V) regardless of the operating voltage or power of the array. The power source input from the photovoltaic source 10 to the inverter may operate as a voltage source or a current source depending on each optimization control method.

The load 50 may refer to a product that uses an electric form used in real life. For example, the inverter 20 may obtain AC power of a desired voltage and frequency through an appropriate conversion method, a switching element, or a control circuit to supply electricity to home appliances in general home appliances or mechanical products in industrial facilities. In addition, in the case of the solar power generation, a period of inactivity in power generation is inevitable when sufficient power generation is not possible due to the nighttime period, for which sunlight is not available, or weather changes. Thus, to compensate for these disadvantages, the photovoltaic systems have to be essentially provided with batteries to ensure stable supply of power.

The battery pack 30 may include at least one of a DC-DC converter, a battery, a battery management system (BMS), and a battery control circuit. The battery may be constituted by a lithium-ion battery or a nickel-metal hydride battery, but is not necessarily limited to this configuration, and may refer to a battery that is capable of being used semi-permanently through charging. The DC-DC converter may be a device that converts the DC power generated through the photovoltaic source 10 into DC power suitable for the battery, or converts the battery power into power suitable for the grid. Generally, power may be converted by converting the DC power into the AC power and then converting the AC power back into the DC power. The battery management system (BMS) may provide functions such as protection of the cells that constitute the battery, equalization between the individual cells, a state of charge (SOC), temperature maintenance, or system monitoring. Thus, based on a sensor that measures a state of the cell and a function that receives a measurement value of the sensor to transmit the measured value to a control system of the application product, a circuit that generates an abnormal signal and blocks or opens the power circuit between the cells when the temperature and charged state of the system exceed a set value may be constructed and controlled.

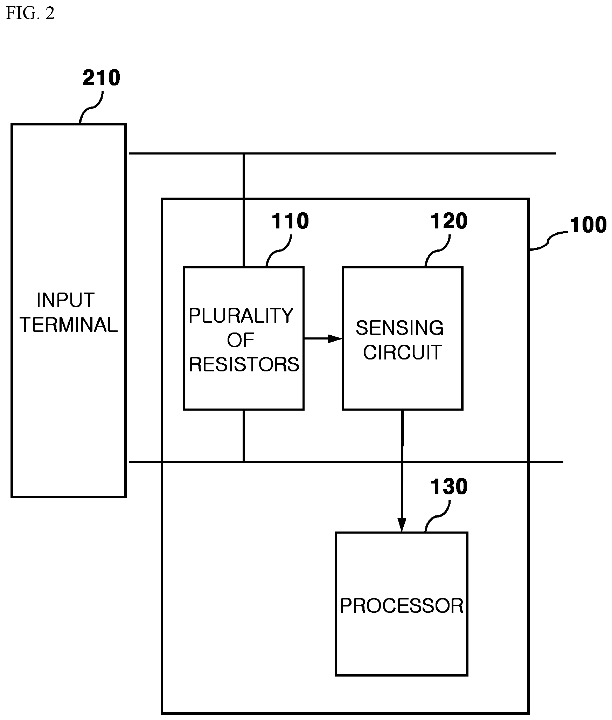

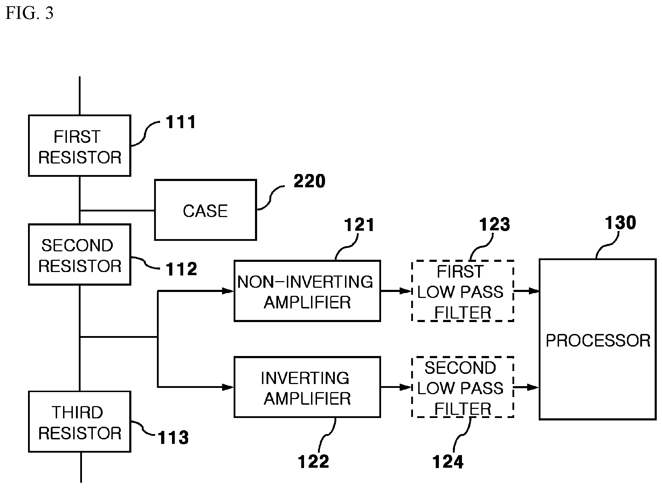

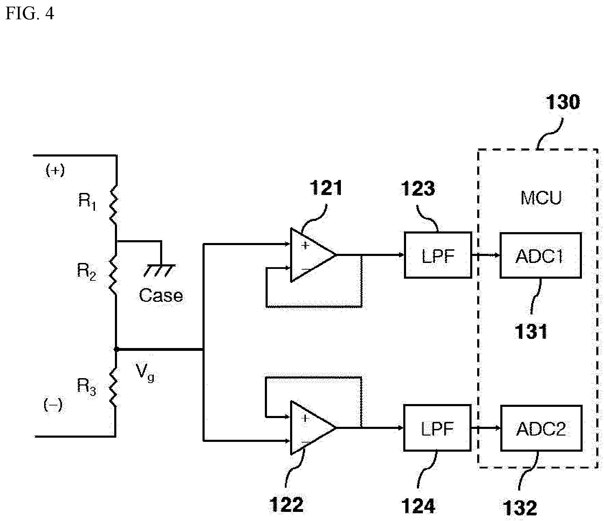

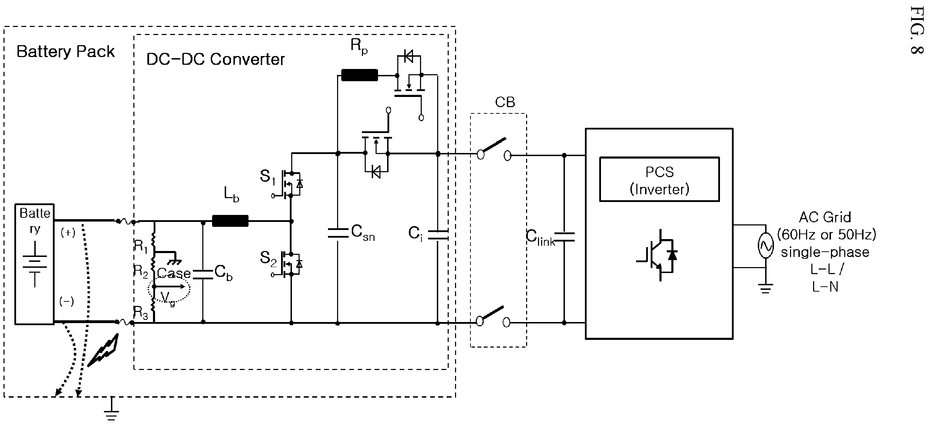

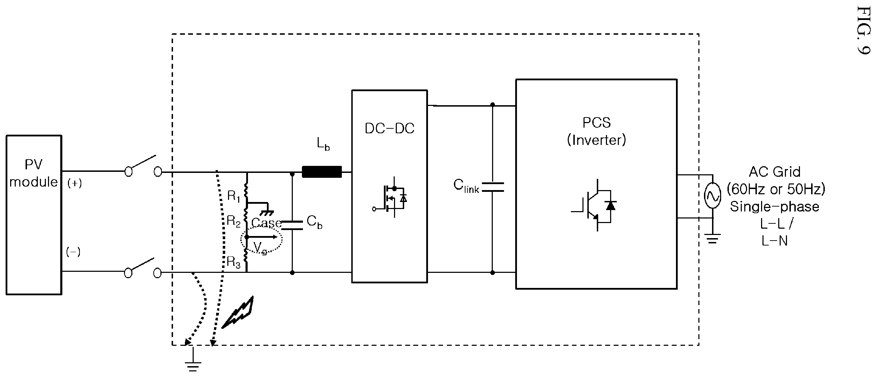

FIG. 2 is a block diagram of a fault detection device according to an embodiment of the present invention. FIG. 3 is a block diagram of a fault detection device according to an embodiment of the present invention, FIGS. 4 to 7 are views for explaining the fault detection device according to an embodiment of the present invention, and FIGS. 8 and 9 are views illustrating an application example to which the fault detection device is applied according to an embodiment of the present invention.

A fault detection device 100 according to an embodiment of the present invention detects a fault due to a contact or ground fault. The contact means that contact occurs and electrical connection occurs between input/output terminals and the case (enclosure) even though the input/output terminals and the case should be insulated from each other. The ground fault and the like may occur due to insulation breakdown, etc. The ground fault means that a ground state is not normal, and the ground terminal is in contact with a location other than the normal location due to an external impact, etc. If the ground or contact fault occurs, damage may occur inside the device or other connected devices when connected to the battery or power device, and overcurrent may occur, resulting in a risk of fire or explosion. To prevent this phenomenon, it is necessary to quickly detect the occurrence of the fault such as the contact or ground fault.

In order to detect the fault such as the contact or ground fault, the fault detection device 100 according to an embodiment of the present invention is constituted by a plurality of resistors 110, a sensing circuit 120, and a processor 130.

The plurality of resistors 110 are connected in series between the input terminals 210 of the converter, the sensing circuit 120 measures a first voltage of one node of the nodes between the plurality of resistors 110, and the processor 130 detects a fault using a change in the first voltage.

The input terminal 210 may be a connection terminal of the converter. Although it is called the input terminal, it may be an input/output terminal that inputs or outputs power. The input terminal 210 may include both terminals such as a plus terminal and a minus terminal. Here, the converter may be a converter used in the photovoltaic system, a DC-DC converter included in the battery pack of the photovoltaic system, or a DC-DC converter connected to a photovoltaic panel. In addition, it is obvious that it may be applied to converters of various devices that input and output power.

The plurality of resistors 110 may include a first resistor 111, a second resistor 112, and a third resistor 113, which are sequentially connected in series from the plus terminal to the minus terminal of the input terminal 210, and a node between the first resistor 111 and the second resistor 112 may be connected to the case 220 of the converter, and the sensing circuit 120 may measure the first voltage at the node between the second resistor 112 and the third resistor 113. In order to detect whether the contact occurs at either of the plus terminal and the minus terminal, the first voltage is measured between the resistors connecting the plus terminal to the minus terminal, and in order to detect a change in the first voltage due to the contact with the case 220, the terminal between the first resistor 111 and the second resistor 112 is connected to be in contact with the case 220. Thus, a voltage of the node between the first resistor 111 and the second resistor 112 may be equal to that of the case 220, and the case 220 may correspond to the lowest voltage of the device on which the converter is mounted. The first voltage is measured by sensing a voltage at the terminal between the second resistor 112 and the third resistor 113.

The sensing circuit 120 measures the first voltage, includes a non-inverting amplifier 121 and an inverting amplifier 122, each of which receives the first voltage, and transmits an output of the inverting amplifier 122 and an output of the non-inverting amplifier 121 to the processor 130. The input terminal 210 of the converter may be connected to the battery or photovoltaic panel, and the output terminal of the converter may be connected to the grid. Since the grid uses the AC voltage, it has a trigonometric waveform with a constant frequency rather than a constant voltage value. For example, it may have a frequency of 60 Hz in a single-phase line to line (L-L) mode, or a frequency of 50 Hz in a single-phase line to neutral (L-N) mode. As a result, the voltages at both the terminals of the input terminal of the converter may also be affected to cause ripples. In addition, during the normal operation, the first voltage has a predetermined offset value, but fluctuates at a predetermined frequency. Here, when the contact occurs between the plus terminal or minus terminal of the input terminal 210, the value of the first voltage may vary depending on whether the plus terminal is in contact with the case 220, or the minus terminal is in contact with the case 220. Thus, in order to detect both the cases, the first voltage is not used as it is, but the first voltage passes through the inverting amplifier 122 and the non-inverting amplifier 121 and then is transmitted to the processor 130. Here, each of the inverting amplifier 122 and the non-inverting amplifier 121 functions as a buffer, but the non-inverting amplifier 121 has the same phase, and the inverting amplifier 122 has an inverted phase.

A first low pass filter (LPF) 123 for filtering the output of the non-inverting amplifier 121 and a second low pass filter 124 for filtering the output of the inverting amplifier 122 may be provided, and the output of the non-inverting amplifier 121 and the output of the inverting amplifier 122 may be applied to the processor 130 through the first low pass filter 123 and the second low pass filter, respectively. The output of the non-inverting amplifier 121 and the output of the inverting amplifier 122 may contain noise. The noise may be removed through the low pass filter to apply only a necessary signal to the processor 130.

The processor 130 may be a micro control unit (MCU) as illustrated in FIG. 4 and may receive a signal through an analog-to-digital converter (ADC) so that the processor 130 utilizes the corresponding value. That is, the output of the non-inverting amplifier 121 and the output of the inverting amplifier 122, which pass through the low pass filters (LPF) 123 and 124, may be received through ADC1 131 and ADC2 132, respectively. The processor 130 may detect a fault by using a difference between the output of the inverting amplifier and the output of the non-inverting amplifier. The output of the inverting amplifier and the output of the non-inverting amplifier have values, of which phases are opposite to each other, and may be expressed as a trigonometric waveform having a predetermined phase regardless of an offset value, regardless of the offset value of the first voltage.

The processor 130 may filter the difference between the output of the inverting amplifier and the output of the non-inverting amplifier using a band pass filter (BPF) that filters a frequency band of the grid and compares a magnitude level of the difference between the filtered output of the inverting amplifier and the output of the non-inverting amplifier with a reference level to detect the fault. The frequency of the difference between the output of the inverting amplifier and the output of the non-inverting amplifier is affected by the frequency of the grid. After removing the offset of the first voltage through the difference between the output of the inverting amplifier and the output of the non-inverting amplifier, the difference between the output of the inverting amplifier and the output of the non-inverting amplifier is filtered using the band pass filter (BPF) that filters the frequency band of the grid. As a result, the noise may be removed, and only a signal needed to detect the fault may be used. Thus, a voltage magnitude level of the difference between the output of the filtered inverting amplifier and the output of the non-inverting amplifier is calculated and compared with the reference level. In case of the contact or ground fault, the fluctuation of the first voltage due to the influence of the grid is reduced according to the connection with the case 220. That is, the voltage magnitude level of the difference between the output of the filtered inverting amplifier and the output of the non-inverting amplifier may decrease, and thus, the processor 130 may compare the decrease of the voltage magnitude level with the reference level, and if the voltage magnitude level of the difference between the output of the filtered inverting amplifier and the output of the non-inverting amplifier is less than the reference level, it may be determined that the fault has occurred. The reference level may be determined based on design or simulation results or may be set by the user.

The processor 130 may determine the fault when the magnitude level of the difference between the output of the filtered inverting amplifier and the output of the non-inverting amplifier is less than the reference level for a predetermined period of time. The magnitude level of the difference between the output of the inverting amplifier and the output of the non-inverting amplifier that has been temporarily filtered may be less than the reference level for a short period of time due to the change in the grid or some configuration of the entire system. In this case, it is possible to immediately determine that it is a fault and does not operate in safe mode, and in temporary cases, the system may operate without determining that it is a fault. The fault determination time may be set to a minimum time, for which the damage to the battery and the like does not occur, and may be set through the design or simulation or may be set by the user.

When the fault is detected, the processor 130 may block the connection of at least one of the input terminal or output terminal of the converter. When it is determined that the fault occurs based on the fault determination, at least one of the input terminal or output terminal of the converter connected to the device may be blocked to prevent the damage to the device, which may be damaged due to the contact. The input or output terminal of the converter may be connected to a circuit breaker. Here, the circuit breaker may include a switch and may be a circuit breaker (CB). In addition, it may include various devices that are capable of blocking the connections, such as relays.

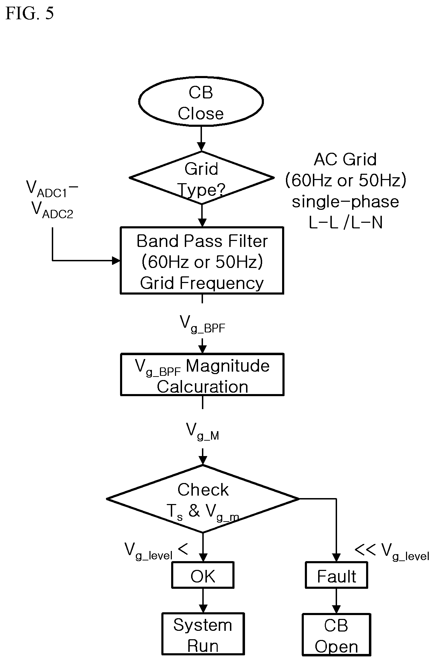

A process of detecting the contact and blocking the connection when the contact is detected may be performed as illustrated in FIG. 5. When the CB that is the circuit breaker is connected, the first voltage is sensed, the output of the inverting amplifier and the output of the non-inverting amplifier are input using the inverting amplifier and the non-inverting amplifier, and the difference between the output of the inverting amplifier and the output of the non-inverting amplifier is calculated. Here, the frequency of the grid is determined according to the type of the grid, and the band pass filter that filters the corresponding band is used to filter the difference between the output of the inverting amplifier and the output of the non-inverting amplifier. Thus, the magnitude level of the difference between the output of the filtered inverting amplifier and the output of the non-inverting amplifier is calculated (V_G_BPF magnitude calculation), and the calculated magnitude level V_G_M is compared with the reference level V_G_LEVEL. When the magnitude level V_G_M is greater than the reference level V_G_LEVEL, it is determined that no contact or ground fault occurs, and the system operates. When the magnitude level V_G_M is equal to or less than the reference level V_G_LEVEL for a given period of time T_S, it is determined that the contact or ground fault occurs, and for safety, the CB is shut off.

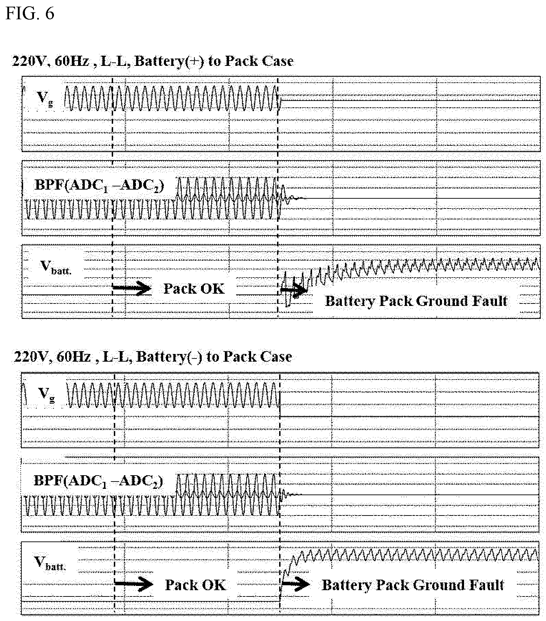

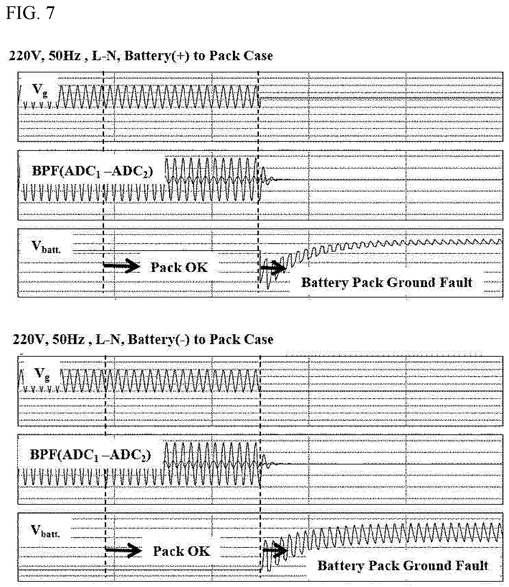

FIG. 6 is a graph illustrating the results of determining the fault when the fault detection device detects the contact of the battery, and the grid type has a frequency of 60 Hz in the L-L mode, and FIG. 7 is a graph illustrating the results of determining the fault when the grid type has a frequency of 50 Hz in the L-N mode. The V_G that is the first voltage has a different value when the fault occurs depending on whether it is connected to the plus or minus terminal, but it may be confirmed that the difference BPF (ADC1-ADC2) between the output of the inverting amplifier and the output of the non-inverting amplifier, which are filtered, decreases in magnitude level, regardless of the V_G value. That is, the contact fault detection may be performed using the difference between the output of the inverting amplifier and the output of the non-inverting amplifier, which are filtered, it may be confirmed that the contact fault detection is possible, regardless of the type of the grid or the position at which the contact occurs.

The converter may be the DC-DC converter inside the battery pack, and in this case, the processor 130 may detect the contact or ground fault of the battery in the battery pack. As illustrated in FIG. 8, the battery pack may include the battery and the converter, and the fault detection device may detect the contact between the case at both ends of the input terminal connected to the battery of the DC-DC converter inside the battery pack. The output terminal of the battery pack may be connected to the grid through the inverter (PCS), and when the fault is detected, the CB connected to the battery output terminal may be opened to cut off the connection with the inverter and the grid. In addition, the connection to the battery and the DC-DC converter may be blocked.

The converter may be the DC-DC converter connected to the photovoltaic module, and at this time, the processor 130 may detect the contact or ground faulty of at least one terminal of both ends of the photovoltaic module input terminal of the DC-DC converter. As illustrated in FIG. 9, the photovoltaic system may include a converter and an inverter, and the fault detection device may detect the contact between the case at both ends of the input terminal connected to the photovoltaic module (PV module) of the DC-DC converter inside the photovoltaic system module. The output terminal of the photovoltaic system may be connected to the grid, and when the fault is detected, the connection to the photovoltaic module may be cut off.

As described above, the first voltage may be detected through the plurality of resistors and the sensing circuit, and the first voltage may be compared with the reference level using the first voltage to detect the fault such as the contact or ground fault. As a result, it may be possible to detect the contact (insulation breakdown) fault in battery power source of the power conversion system for the solar power and the grid-connected ESS.

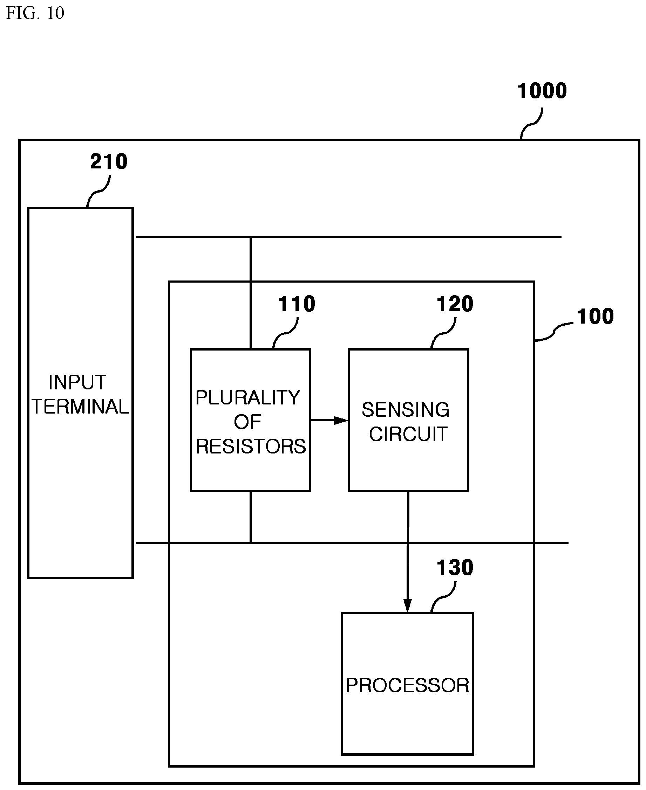

FIG. 10 is a block diagram of a DC-DC converter according to an embodiment of the present invention.

The DC-DC converter 1000 according to an embodiment of the present invention includes an input terminal 210 connected to a battery or a photovoltaic panel and a fault detection circuit that detects a contact or ground fault of at least one terminal of both ends of the input terminal. A detailed description of the fault detection circuit of the DC-DC converter 1000 according to an embodiment of the present invention corresponds to the detailed description of the fault detection device of FIGS. 1 to 9, and any duplicated description will be briefly described below.

The DC-DC converter 1000 of the present invention is connected to the battery or photovoltaic panel through an input terminal 210 to convert input power and then output the converted power. The DC-DC converter 1000 may be a DC-DC converter included in the battery pack, and at this time, power may be received from the battery, converted, and output, and the output power may be transmitted to the grid through an inverter. Alternatively, power may be received from the photovoltaic panel or the grid and then converted to charge the battery. The DC-DC converter 1000 may be a DC-DC converter included in a photovoltaic module, and may receive power generated from the photovoltaic panel to converts the received power and then outputs the converted power. The output power may be transmitted to the grid through the inverter or may be used to charge the battery.

The fault detection circuit detects a contact or ground fault of at least one terminal of the input terminal of the DC-DC converter. The fault detection circuit may include a plurality of resistors 110 which are connected in series between both input terminals of the converter, a sensing circuit 120 which measures a first voltage at one of nodes between the plurality of resistors, and a processor 130 which detects the fault by using a change in the first voltage.

Here, the plurality of resistors may include a first resistor, a second resistor, and a third resistor, which are sequentially connected in series from a plus terminal to a minus terminal of the input terminal 210, a node between the first resistor and the second resistor may be connected to a case of the converter 1100, and the sensing circuit 120 may measure the first voltage at a node between the second resistor and the third resistor. The sensing circuit 120 may include an inverting amplifier and a non-inverting amplifier, each of which receives the first voltage, and the output of each of the inverting amplifier and the output of the non-inverting amplifier may be applied to the processor 130.

In addition, a first low pass filter for filtering the output of the inverting amplifier and a second low pass filter for filtering the output of the non-inverting amplifier may be provided, and the output of the inverting amplifier and the output of the non-inverting amplifier may be applied to the processor 130 through the first low pass filter and the second low pass filter, respectively, and the processor 130 may detect the fault by utilizing a difference between the output of the inverting amplifier and the output of the non-inverting amplifier.

The output terminal of the converter may be connected to the grid, and the processor 130 may filter the difference between the output of the inverting amplifier and the output of the non-inverting amplifier using a band pass filter that filters a frequency band of the grid and compares a magnitude level of the difference between the filtered output of the inverting amplifier and the output of the non-inverting amplifier with a reference level to detect the fault. The processor 130 may determine that the fault occurs when the magnitude level of the difference between the output of the filtered inverting amplifier and the output of the non-inverting amplifier is less than the reference level for a predetermined period of time. When the fault is detected, the processor 130 may block the connection of at least one of the input terminal or output terminal of the converter. This will protect the entire system.

The converter 1000 may be the DC-DC converter inside the battery pack, and the processor 130 may detect the contact or ground fault of the battery in the battery pack. Alternatively, the converter 1000 may be the DC-DC converter connected to the photovoltaic module, and the processor 130 may detect the contact or ground faulty of at least one terminal of both ends of the photovoltaic module input terminal of the DC-DC converter.

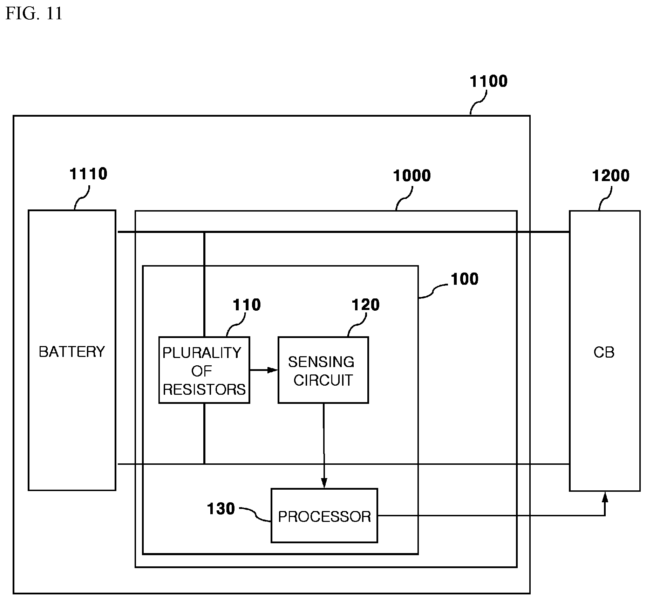

FIG. 11 is a block diagram of a battery pack according to an embodiment of the present invention.

A battery pack 1100 according to an embodiment of the present invention includes a battery 1110, a DC-DC converter 1000 that converts a voltage of the battery 1110, and a fault detection circuit that detects a contact or ground fault in the battery 1110. A detailed description of the DC-DC converter 1000 and the fault detection circuit of the battery pack 1100 according to an embodiment of the present invention corresponds to the detailed description of the fault detection device of FIGS. 1 to 9 and the DC-DC converter of FIG. 10, and thus, any duplicated description will be briefly described below.

The battery pack 1100 of the present invention may convert power of the battery 1110 disposed inside into power by the DC-DC converter 1000 to output the power, and the output power may be transmitted to the grid through an inverter. Alternatively, it may receive power from a photovoltaic panel or a grid to convert the power and then charge the battery.

The fault detection circuit detects a contact or ground fault of at least one terminal of both ends of the battery 1110. The fault detection circuit may include a plurality of resistors 110 which are connected in series between both the ends of the battery 1110, a sensing circuit 120 which measures a first voltage at one of nodes between the plurality of resistors, and a processor 130 which detects the fault by using a change in the first voltage.

Here, the plurality of resistors may include a first resistor, a second resistor, and a third resistor, which are sequentially connected in series from a plus terminal to a minus terminal of the input terminal 210, a node between the first resistor and the second resistor is connected to a case of the battery pack 1100, and the sensing circuit 120 may measure the first voltage at a node between the second resistor and the third resistor. The sensing circuit 120 may include an inverting amplifier and a non-inverting amplifier, each of which receives the first voltage, and the output of each of the inverting amplifier and the output of the non-inverting amplifier may be applied to the processor 130.

In addition, a first low pass filter for filtering the output of the inverting amplifier and a second low pass filter for filtering the output of the non-inverting amplifier may be provided, and the output of the inverting amplifier and the output of the non-inverting amplifier may be applied to the processor 130 through the first low pass filter and the second low pass filter, respectively, and the processor 130 may detect the fault by utilizing a difference between the output of the inverting amplifier and the output of the non-inverting amplifier.

The output terminal of the converter may be connected to the grid, and the processor 130 may filter the difference between the output of the inverting amplifier and the output of the non-inverting amplifier using a band pass filter that filters a frequency band of the grid and compares a magnitude level of the difference between the filtered output of the inverting amplifier and the output of the non-inverting amplifier with a reference level to detect the fault. The processor 130 may determine that the fault occurs when the magnitude level of the difference between the output of the filtered inverting amplifier and the output of the non-inverting amplifier is less than the reference level for a predetermined period of time. When a fault is detected, the processor 130 may block a circuit breaker (CB), which is a circuit breaker connected to the output terminal of the battery pack 1100 to control an on/off of connection with the outside. This will protect the , entire system.

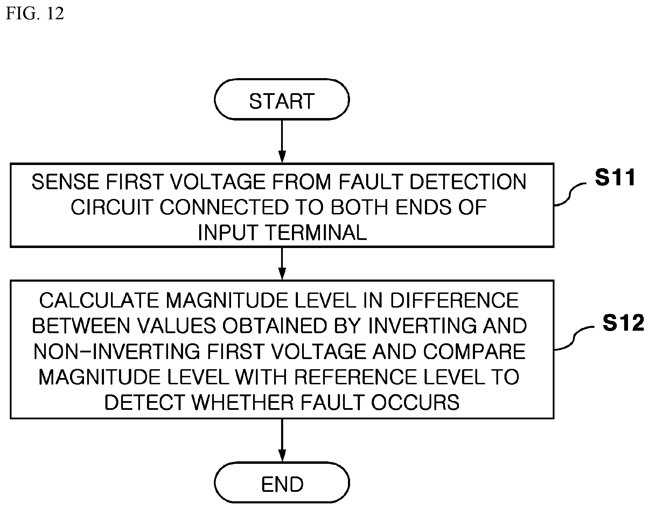

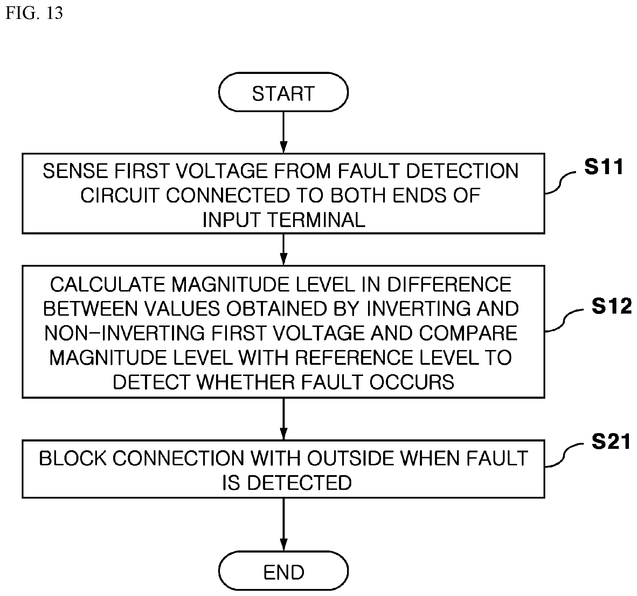

FIG. 12 is a flowchart of a fault detection method according to an embodiment of the present invention, and FIG. 13 is a flowchart of a fault detection method according to an embodiment of the present invention. Detailed descriptions of each process in FIGS. 12 and 13 correspond to the detailed descriptions of the fault detection device of FIGS. 1 to 11, and any duplicated description will be briefly described below.

In order to detect a contact or ground fault of a battery or photovoltaic panel connected to an input terminal of a DC-DC converter, a first voltage is sensed from a fault detection circuit connected to both ends of the input terminal in operation S11.

Here, the fault detection circuit may include a plurality of resistors which are connected in series between both the ends of the battery and a sensing circuit which measures a first voltage at one of nodes between the plurality of resistors to detect the fault by using a change in the first voltage. The plurality of resistors may include a first resistor, a second resistor, and a third resistor, which are sequentially connected in series from a plus terminal to a minus terminal of the input terminal, a node between the first resistor and the second resistor may be connected to a case of the converter, and the sensing circuit may measure the first voltage at a node between the second resistor and the third resistor.

Thereafter, in operation S12, a magnitude level in difference between values obtained by inverting and non-inverting the first voltage is calculated and then compared with a reference level to detect whether there is a fault. The sensing circuit may include an inverting amplifier and a non-inverting amplifier, each of which receives the first voltage, and may detect whether there is the fault using outputs of the inverting amplifier and the output of the non-inverting amplifier. Here, a first low pass filter for filtering the output of the inverting amplifier and a second low pass filter for filtering the output of the non-inverting amplifier may be provided to receive the output of the inverting amplifier and the output of the non-inverting amplifier through the first low pass filter and the second low pass filter, respectively, and the fault may be detected by utilizing a difference between the output of the inverting amplifier and the output of the non-inverting amplifier.

The output terminal of the converter may be connected to the grid, and the band pass filter that filters a frequency band of the grid may be used to filter the difference between the output of the inverting amplifier and the output of the non-inverting amplifier, and the fault may be detected by comparing the magnitude level of the difference between the output of the inverting amplifier and the output of the non-inverting amplifier, which are filtered, with the reference level. Here, when the magnitude level in difference between the output of the filtered inverting amplifier and the output of the non-inverting amplifier is less than the reference level for a predetermined period of time, it may be determined that the fault occurs.

When the fault is detected in operation S12, the connection to the outside may be blocked in operation S21. When the fault is detected, the system may be protected by blocking a circuit breaker (CB), the circuit breaker that turns the connection with the outside on and off.

Moreover, embodiments of the present invention can also be embodied as computer readable codes on a computer readable recording medium. The computer readable recording medium includes all types of recording devices in which data readable by a computer system is stored.

Examples of the computer-readable storage medium may include a ROM, a RAM, a CD-ROM, a magnetic tape, a floppy disk, an optical data storage device, etc., and furthermore, the computer-readable storage medium may be distributed across a network-connected computer system, and thus, a computer-readable code may be stored and executed in a distributed manner. Also, functional programs, codes, and code segments for accomplishing the present invention can be easily construed by programmers skilled in the art to which the present invention pertains.

It will be understood by those skilled in the art that various changes in form and details may be made therein without departing from the spirit and scope of the invention as defined by the appended claims. Therefore, the disclosed methods should be considered in descriptive sense only and not for purposes of limitation. Therefore, the scope of the invention is defined not by the detailed description of the invention but by the appended claims, and all differences within the scope will be construed as being included in the present invention.

## Claims

1. A fault detection device comprising:
a plurality of resistors connected in series between both ends of an input terminal of a converter;
a sensing circuit configured to measure a first voltage at one of nodes between the plurality of resistors; and
a processor configured to detect a fault by using a change in the first voltage.

2. The fault detection device according to claim 1, wherein the plurality of resistors comprises a first resistor, a second resistor, and a third resistor, which are sequentially connected in series from a plus terminal to a minus terminal of the input terminal,
wherein a node between the first resistor and the second resistor is connected to a case of the converter, and
wherein the sensing circuit measures the first voltage at a node between the second resistor and the third resistor.

3. The fault detection device according to claim 1, wherein the sensing circuit comprises an inverting amplifier and a non-inverting amplifier, and
wherein an output of the inverting amplifier and an output of the non-inverting amplifier are applied to the processor.

4. The fault detection device according to claim 3, comprising:
a first low pass filter configured to filter the output of the non-inverting amplifier; and
a second low pass filter configured to filter the output of the inverting amplifier,
wherein the output of the inverting amplifier and the output of the non-inverting amplifier are applied to the processor through the first low pass filter and the second low pass filter, respectively.

5. The fault detection device according to claim 3, wherein the processor detects a fault by using a difference between the output of the inverting amplifier and the output of the non-inverting amplifier.

6. The fault detection device according to claim 5, wherein an output terminal of the converter is connected to a grid, and
wherein the processor is configured to:
filter the difference between the output of the inverting amplifier and the output of the non-inverting amplifier by using a band pass filter configured to filter a frequency band of the grid; and
compare a magnitude level in difference between the output of the inverting amplifier and the output of the non-inverting amplifier, which are filtered, with a reference level and detect the fault.

7. The fault detection device according to claim 6, wherein the processor determines that the fault occurs when the magnitude level in difference between the output of the inverting amplifier and the output of the non-inverting amplifier, which are filtered, is less than the reference level for a predetermined period of time.

8. The fault detection device according to claim 1, wherein, when detecting the fault, the processor blocks connection of at least one of the input terminal or an output terminal of the converter.

9. The fault detection device according to claim 1, wherein the converter comprises a DC-DC converter inside a battery pack, and
wherein the processor detects contact fault or ground fault of a battery of the battery pack.

10. The fault detection device according to claim 1, wherein the converter comprises a DC-DC converter connected to a photovoltaic module, and
wherein the processor detects a contact fault or ground fault of at least one terminal of both ends of an photovoltaic module input terminal of the DC-DC converter.
